(19) Europäisches Patentamt
European Patent Office
Office européen des brevets

(11) **EP 2 999 116 A1**

(12) **EUROPEAN PATENT APPLICATION**

(43) Date of publication:
**23.03.2016 Bulletin 2016/12**

(51) Int Cl.:
*H03K 5/01* (2006.01)    *H04B 1/04* (2006.01)

(21) Application number: **15184603.7**

(22) Date of filing: **10.09.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **19.09.2014 EP 14185626**

(71) Applicant: **IMEC VZW**
**3001 Leuven (BE)**

(72) Inventor: **INGELS, Mark Maria Albert**
**3001 Leuven (BE)**

(74) Representative: **DenK iP**
**Hundelgemsesteenweg 1114**
**9820 Merelbeke (BE)**

(54) **DIRECT DIGITAL RADIO FREQUENCY MODULATOR**

(57)    The present invention relates to a direct digital radio frequency modulator (10) comprising a plurality of input terminals (11) arranged for being fed with a multi-bit digital signal (D), a plurality of converter circuits (CCi), each converter circuit being arranged for receiving at an input terminal one bit of said multi-bit digital signal and for outputting at a converter circuit output terminal (OUTi) an analog signal (Ai) in accordance to said one bit, each converter circuit comprising an input transistor (T1) arranged for receiving said one bit for enabling the converter circuit to produce said analog signal, a current source transistor (T2) and a frequency modulator output terminal (12) connected to the output terminal of each converter circuit for providing an analog output signal (A), characterized in that said converter circuit further comprises an additional transistor (T3) in cascode to said current source transistor (T2).

**Fig. 3**

## Description

## Field of the invention

The present invention is generally related to the field of radio devices and more specifically to direct digital radio frequency modulators for a radio device.

## Background of the invention

Radio transmitters are an important part of wireless systems. Thanks to the speed improvement of CMOS technology, analog radio frequency (RF) transmitters can now be integrated in CMOS together with complex baseband processors. However, the parameters of a CMOS transistor which are important for the analog RF design, such as output impedance, supply versus threshold ratio or intrinsic gain typically worsen with the advance of the CMOS technological nodes. Furthermore, modern communication schemes impose tough requirements on radio transmitters. Transmitters operating at RF have to combine hard requirements such as RF bandwidth, linearity and out-of-band noise while maintaining a high efficiency. As a result, the porting of an analog RF transmitter from one technological node to another is complicated and thus slow and costly. Thus, transmitters need to have the least analog circuitry as possible. In addition, it is desirable for radio transmitters to be easily scalable with the advancement of CMOS technologies.

To address the problem of analog RF transmitters, a new family of RF transmitters, digital transmitters comprising Direct Digital RF Modulators (DDRM), has been adopted. The digital transmitters feature predominantly digital circuitry which is better suited for advanced CMOS technology and which scales much better with the various CMOS technological nodes. In contrast to their analog counterpart, the performance of digital transmitters intrinsically improves with the scaling of CMOS technology.

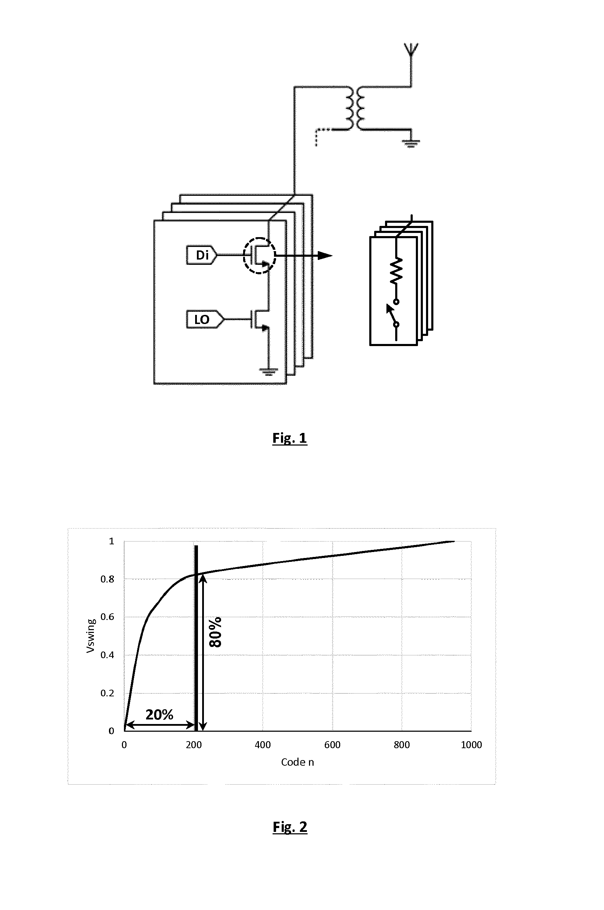

In practical realizations, the DDRM comprises unit amplifier cells typically laid out in a matrix, comparable to a DAC matrix, as shown in Fig.1. Both the digital data streams D and the various local oscillator phases LO have to be routed to all the unit amplifier cells in the matrix. Due to the large number of unit cells and the size of the LO switches, the load of the local oscillator (LO) paths is significant. Actually, a main contributor to the total power consumption of a DDRM is the distribution of the LO signal to the various DDRM unit amplifier cells. Indeed, as these cells have to provide the power to the antenna, the corresponding switch transistors in each cell are relatively large and the routing to the DDRM cells is relatively long. The power related to the LO distribution to the cells is thus considerable.

The first digital transmitters were based on a polar architecture, in which a phase modulated LO is fed to a multitude of DDRM units and amplitude modulation is performed by enabling or disabling (switching on or off) these DDRM unit amplifiers and then combining their output power to form a modulated RF analog signal. Later, Cartesian DDRM architectures consisting of two such digital amplitude modulators, for modulating the in-phase (I) and the quadrature (Q) signals with the respective LO phases, were also adopted in digital transmitters. The outputs of these two digital amplitude modulators are summed before being fed to the antenna for transmission.

To obtain high efficiency, the design of the DDRM unit amplifier typically starts from a switching amplifier architecture, such as an inverse class-D. In practice, an ideal switching behaviour is actually only true at full output power. To perform the modulation, the large switch of the switching amplifier is split into a multitude of small units, N. Actually, in order to achieve modulation in this way the series resistance of the non-ideal switch has to be considered. In the digital modulator the large switch with small series resistance is actually built up as a parallel combination of a multitude of small switches with larger series resistance (due to the smaller device size of each switch). At full power, all switches are open in parallel, resulting in the small resistance. Obviously, the system aims to make the total resistance of the N switches as small as possible.

Splitting up the big switching amplifier into a multitude of smaller switches in the digital modulator is similar to creating a digitally tunable resistor. In practice, the digital transmitter described above, contains a multitude of small resistors in parallel that can be switched on or off as shown in Fig.1. If the resistance of a single switch transistor is Ri, the minimal resistance Rmin = Ri/N is obtained at full power when all N transistor switches are turned on. For a given load impedance Zload and a given supply voltage Vdd, the output swing Vout over the load impedance of this digital transmitter is determined by the ratio between the fixed Zload and the modulated (switch) resistance. This is a highly non-linear relation given by:

$$\mathbf{Vout} = \frac{\text{Zload}}{\text{Zload} + \frac{\text{Ri}}{n}} \qquad (1)$$

wherein n is the baseband code determining the number of active units. This non-linear relation requires a significant pre-distortion of the transmitted signal. The same non-linear relation is also observed in a Cartesian-based DDRM implementation. The corresponding supplementary digital processing results in an inherent area increase and, more importantly, in a power penalty.

An even bigger problem related to the non-linear behaviour is the loss in effective resolution. This is demonstrated in Fig.2. In the given example, 80% of the output swing is generated from only 20% of the digital baseband codes. Although pre-distortion will map the input codes such that the response is linearized, the number of codes effectively used over the full output range is reduced, and so is the effective resolution. This is especially true in the lowest (80%) range of the output swing, where the resolution is actually most needed, as modern communication schemes typically feature high PAPR (Peak to Average Power Ratio). The reduction of effective resolution is a major drawback in digital transmitters which target very low out of band quantization noise.

Obviously, there is a need for avoiding or overcoming these drawbacks.

## Summary of the invention

It is an object of embodiments of the present invention to provide for a direct digital radio frequency modulator overcoming the disadvantages of the conventional designs.

The above objective is accomplished by the solution according to the present invention.

In a first aspect the invention relates to a direct digital radio frequency modulator comprising a plurality of input terminals arranged for being fed with a multi-bit digital signal, a plurality of converter circuits, each converter circuit being arranged for receiving at an input terminal one bit of the multi-bit digital signal and for outputting at a converter circuit output terminal an analog signal in accordance to said one bit. Each converter circuit comprises an input transistor arranged for receiving said one bit for enabling the converter circuit to produce the analog signal, a current source transistor and a frequency modulator output terminal connected to the output terminal of each converter circuit for providing an analog output signal, characterized in that the converter circuit further comprises an additional transistor in cascode to the current source transistor.

The proposed solution indeed allows achieving an efficient performance of the direct digital radio frequency modulator. Due to the fact that it is current source based, a better linear behaviour is established. The additional transistor in cascode makes sure that output impedance variations remain small compared to the load impedance. The transistor in cascade increases the output impedance drastically.

In one embodiment the direct digital radio frequency modulator comprises a circuit arranged for summing said analog signal produced by each respective converter circuit to form the analog output signal at the output terminal of the frequency modulator.

In some embodiments the multi-bit digital signal is a modulated radio frequency multi-bit digital signal. The modulated radio frequency multi-bit digital signal may be a modulated I/Q data signal or a modulated polar data signal.

In other embodiments the current source transistor in each respective converter circuit is configured to receive a bias voltage. The bias voltage may be adjustable.

In yet another embodiment the additional transistor is a thick-oxide transistor.

The present disclosure relates as well to a front-end radio system comprising: a direct digital radio frequency modulator according to the present invention and a digital signal processor arranged for outputting a multi-bit digital signal.

In some embodiments the digital signal processor comprises a modulator circuitry arranged for modulating a digital baseband signal with a radio frequency signal and for outputting said multi-bit digital signal. The multi-bit digital signal may be a modulated I/Q data signal or a modulated polar data signal.

The present disclosure also relates to a radio device comprising a front-end system according to the present disclosure and to a communication network comprising at least one such radio device.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

## Brief description of the drawings

The invention will now be described further, by way of example, with reference to the accompanying drawings, wherein like reference numerals refer to like elements in the various figures.

Fig.1 illustrates a conventional resistor based digital amplitude modulator.
Fig.2 illustrates a non-linear response of a conventional resistor based digital amplitude modulator.
Fig.3 illustrates a block diagram of the direct digital radio frequency modulator (DDRM) according to the present invention.
Fig.4 illustrates a schematic of a converter circuit according to an exemplary embodiment.
Fig.5 illustrates the effect of variations in the output impedance of the DDRM according to the present disclosure on its gain (left plot) and on the phase of the tuned network (right plot).
Fig.6A illustrates a schematic of a converter circuit according to an exemplary embodiment. Fig.6B and Fig.6C show the output analog signal of the converter circuit of Fig.6A for two different examples of an input digital signal.

Fig.7A illustrates a schematic of a converter circuit according to an exemplary embodiment. Fig.7B shows the output analog signal of the converter circuit of Fig.7A for an example of an input digital signal.

Fig.8 illustrates a block diagram of a front-end system of a radio device comprising a direct digital radio frequency modulator according to the present invention.

Fig.9 illustrates a block diagram of a front-end system of a radio device comprising the direct digital radio frequency modulator according to the present invention.

Fig.10 illustrates a block diagram of a front-end system of a radio device comprising the direct digital radio frequency modulator according to the present invention.

Fig.11 illustrates a schematic of a digital transmitter comprising a direct digital radio frequency modulator according to the present invention.

Fig.12 illustrates a schematic of a digital transmitter comprising a direct digital radio frequency modulator according to the present invention.

## Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

Conventional direct digital radio frequency modulators (DDRM) are designed for low output impedance at full power and are typically derived from switching amplifiers. However, when applying digital modulation, these DDRMs effectively operate similarly to a modulated resistor due to the series resistance of the switch transistor of each DDRM cell. This operation can be equated to a voltage divider with fixed load impedance which has a non-linear response. To compensate for this non-linear response a considerable amount of pre-distortion is required in digital transmitters employing such DDRMs. In addition, conventional DDRM need the various LO phases to be distributed to each of the units in which based on the digital baseband data which is also being distributed to these unit a local decoding circuit determines whether the unit is active or not. The distribution of the LO to the various units results in a considerable power consumption, as the routing to the multitude of units represents a considerable load to the LO drivers which distribute the high frequency LO signal to the units.

The present disclosure relates to a current source based DDRM. Differently from a conventional DDRM, in a current source DDRM a very high output impedance is targeted. In the proposed current source based DDRM, a unit DDRM cell comprises a current source transistor rather than a (resistive) switch as in conventional designs. The proposed current source based DDRM targets to maximize the output impedance of the DDRM, even at maximal code and high output power. This is highly uncommon in digital transmitter RF design, where the tendency is to reduce the output impedance of the transmitter, rather than to increase it. Using a current source based DDRM allows achieving an operation with a linear response. The output current of the DDRM is given by the number of active units cells multiplied by the unit current of the active cells. In addition, according to the present disclosure, a local DSP is placed outside the matrix of the DDRM. The DSP determines which DDRM unit cells have to be activated at any given moment in time, and a modulated LO signal is distributed only to these active cells. As a result, no power is lost in distributing the LO signal to inactive cells, which results in a better overall efficiency of the overall transmitter.

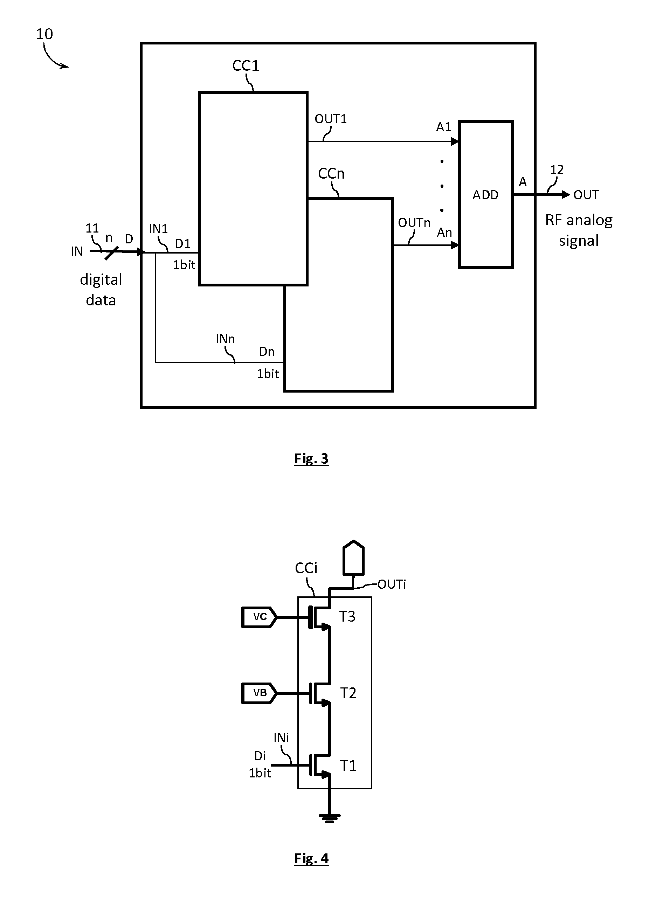

Fig.3 shows a Direct Digital RF modulator (DDRM) 10 according to the present disclosure. The DDRM 10 receives at its input 11 a multi-bit digital signal D and outputs an RF analog signal at its output 12. The multi-bit digital signal D is the LO signal masked by the baseband data (i.e. I/Q data or polar data). The LO signal is combined with the baseband data in a digital circuit, such as a DSP, to create the multi-bit digital signal D, which is then the input to the DDRM. The DDRM 10 comprises a plurality of converter circuits CCi, each converter circuit arranged for receiving at its respective input terminal INi (i=1 to n) one bit Di (i=1 to n) of the multi-bit digital signal D. Based on the received bit Di, each converter circuit CCi outputs at its output terminal OUTi an analog signal Ai. The DDRM output terminal 12 is connected to the output of each converter circuit OUTi (i=1 to n) for providing an output analog signal A.

Fig.4 shows an example implementation of a unit cell CCi according to an embodiment of the present disclosure. The unit converter circuit CCi comprises an input transistor T1 connected in series to a current source transistor T2. The input transistor T1 is arranged for receiving one bit Di of the multi-bit digital signal D. Depending on the bit value, a logical one '1' or logical zero '0', the input transistor T1 which acts as a switch transistor is switched on or off. Accordingly, the conversion cell is enabled or disabled. When T1 is enabled (Di = '1'), the current source transistor T2 generates an analog signal Ai at the output OUTi of the cell. In other words, the switch transistor T1 determines whether a current is flowing through the current source transistor T2. The value of that current is mainly determined by the bias voltage VB applied at the gate terminal of T2 and the dimensions of transistor T2. By adjusting the bias voltage VB, the value of the current flowing, i.e. the amplitude of the analog signal Ai, can be adjusted. Consequently, digital modulation is achieved by the current flowing through the current source T2 and not, as in conventional DDRM implementations, by the resistance of the switch transistor T1. The resistance of the switch transistor T1 only results in some extra power dissipation when a current is flowing through the activated unit cell. Its resistance value should thus be chosen low enough to limit this dissipation and, hence, the degradation of the efficiency of the DDRM. As the bias voltage of transistor T2 and its dimensions determine the current of the active unit cells, it determines the output power of the transmitter. While the current is constant during operation of the cell (and thus contributes to the modulation), the current may be adjusted to control the RMS output power of the transmitter and thus its gain.

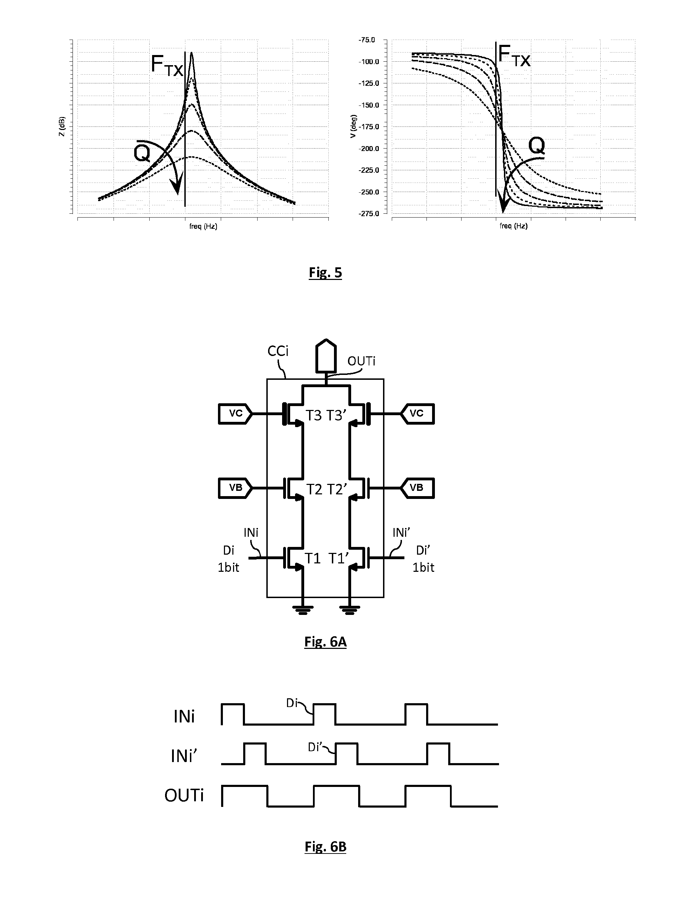

While the distortion of the output signal in a current based radio transmitter device is much smaller than for a resistor based modulator, it is not zero as the current source DDRM does not have infinite output impedance. Furthermore, in practice when operating at RF frequency, the load of the DDRM (not shown in the figure) is not resistive but typically consists of a tuned network, i.e. a tuned inductor for a single-ended transmitter or a tuned balun for a differential transmitter. While this load is typically tuned to centre the output frequency to the resonance of the tuned network, the limited resolution of the tuning network inevitably results in a slightly off-centred operating frequency with respect to the resonance. As the output impedance of the DDRM modulator is not infinite, it contributes to the quality factor (Q) of the tuned network. As a result, variations of the output impedance of the modulator vary the Q of the tuned network. As shown in Fig.5, this does not only impact the gain of DDRM modulator (left plot), but it also impacts the phase of the tuned network (right plot) and results in both AM to AM and AM to PM distortion. Thus, keeping the output impedance variation small relative to the load impedance is extremely important to avoid the need for pre-distortion.

To keep the output impedance variation small with respect to the load impedance, the converter circuit CCi further comprises an additional transistor T3 in cascode to the current source transistor T2, as shown in Fig. 4. The purpose of the cascode transistor T3 is to increase the output impedance of the current source T2 drastically as:

$$Rout \approx Ro_{T2} \cdot gm_{T3} \cdot Ro_{T3}. \qquad (2)$$

where gmT3 is the transconductance of transistor T3, and RoT2 and RoT3 the output impedance of transistors T2 and T3, respectively. As the output impedance of the DDRM can be considered in parallel with the load to the DDRM, the actual load seen by the DDRM is a parallel circuit of the effective load and its own output impedance. The higher this output impedance, the lower its contribution, and the lower the impact of variations of this output impedance. Consequently, the increased output impedance further improves the linear operation of the DDRM and limits the AM-AM and AM-PM distortion so that the need for pre-distortion is avoided. In the disclosed current based DDRM, pre-distortion may be caused only if parasitics are present. Predistortion due to a non-linear response of a DDRM, as in a conventional resistor based DDRM, is eliminated.

Fig.6A shows a Cartesian conversion cell CCi, according to another embodiment of the present disclosure. In this implementation, the unit cell CCi contains a path for the amplitude modulation of the in-phase (I) signal and a path for the modulation of the quadrature (Q) signal. Both paths are identical to the implementation of Fig.4. Each cell's path receives at its input INi,INi' a single bit Di,Di' from a multi-bit digital signal Di,Di'. Each of the multi-bit digital signals D,D' is the LO signal combined with the in-phase (I) and the quadrature phase (Q) baseband data, respectively. This effectively results in masking the LO signal with the baseband data to generate two multi-bit digital signals D,D', one for each respective I and Q baseband data. These are herein referred to as I-modulated LO signal ($LO_I$) and Q-modulated LO signal ($LO_Q$). The digital signals D,D' can be generated by a digital circuit, such as a DSP, which combines the baseband bits, i.e. the I/Q data, with the LO signal. The input transistors T1,T1' act as a switch to enable or disable the respective path of the conversion cell CCi in accordance with the received bits Di,Di'. On top of each switch T1, T1' is a current source transistor T2,T2', biased with a bias voltage VB. The switch transistors T1,T1' determines whether a current is flowing or not through the respective current source transistors T2,T2', which value is determined by the applied bias voltage VB and the dimensions of the current source transistors T2,T2'. An adjustable bias voltage is applied to each cell CCi to control the current provided by the cells. By controlling this bias voltage, the gain of the DDRM can be controlled, as a higher bias voltage corresponds to a higher unit current in each cell and a larger modulated current swing, and, thus, to a higher gain. While in the most simple case the bias voltage VB can be equal for each unit cell, different bias voltages may be applied to each cell for calibration, i.e. to adjust for current source mismatches from one cell to another.

As the current value is determined by the bias voltage and the dimensions of transistors T2,T2', the size of the switch transistors T1,T1' is of less importance than in the resistor based case, i.e. conventional DDRM implementations. Here, the resistance of the switch transistors T1,T1' should be low enough not to disrupt the current source's current.

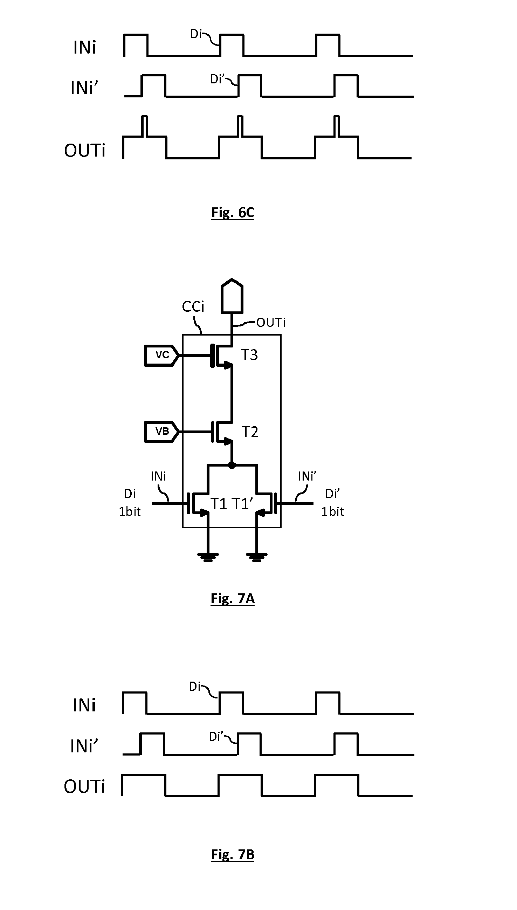

At the output OUTi of the cell CCi, the currents in each path of the cell are combined (summed together) after transistors T3,T3' to form the output current. The current summation is thus performed in the analog domain, at the very output of the conversion cell. In case of an overlap between the input bit streams Di,Di' no loss of information, or signal distortion, is observed. This is illustrated in Fig.6B and Fig.6C. Fig.6B shows the operation of the conversion cell when no overlap is present between the received Di and Di' bit streams. For the given bit stream of Di (I-modulated LO signal) and Di' (Q-modulated LO signal) at the respective cell's input INi,INi', an output current at the output OUTi is generated. Fig.6C shows that operation of the cell, when an overlap between the bit streams is present. The overlap results in a temporary increase of the output current as the current of each cell's path are summed in analog domain. This is a desired behaviour, as it results in a correct summation of I-modulated and Q-modulated signals. A duty cycle higher than 25% for both I and Q can be used. As the efficiency of the conversion cell CCi is inversely proportional to the duty cycle, a lower duty cycle, e.g. 25% duty cycle, is preferred.

Fig.7A shows a Cartesian conversion cell CCi with a single current source transistor T2 and a single cascode transistor T3, according to another embodiment of the present disclosure. In this embodiment, at each input IN,IN' the cell CCi receives a single bit Di,Di' from each multi-bit data stream D,D'. The information of the data streams Di,Di' is combined with transistors T1,T1' which perform a logical 'OR' function. The summation of the bit streams, i.e. the summation of the $LO_I$ and $LO_Q$ signals is done logically, and not in analog as in the embodiment of Fig.6. This implementation has the advantage of resulting in a smaller area (reduced number of transistors) and better I/Q matching (as the current for both the I and Q components of the output signal are generated by the same current source T2 and cascode transistor T3). Fig.7B shows the operation of the conversion cell when overlap is present between the input bit streams Di,Di'. In this case, no extra current is present at the output OUTi in the overlapping period, in contrary to the example given in Fig.6C. The signal summation is incorrect as the integral over time of the current of the sum of the two adjacent active phases will be different from the sum of the integral over time of each active phase individually. This results in distortion of the output signal. As non-overlapping phases are needed in this implementation, the Di and Di' streams have a maximal 25% duty cycle. To avoid overlap in practice, the duty cycle would have to be reduced far below 25% to avoid that one phase interacts with the other, especially when transmitting at high RF frequencies. This would make it very difficult to realize these narrow pulses accurately. Furthermore, the current of the unit cells would have to be increased, as for a given current value narrower pulses result in lower output power (the transmitted power is related to the product of the height of the current pulse with the pulse duration). To avoid such distortion even in the presence of overlapping I/Q modulated LO phases, a calibration algorithm may be used as described by Chunshu Li et. al. in the paper "Efficient self-correction scheme for static non-idealities in nano-scale quadrature digital RF transmitters" (2013 IEEE Workshop on Signal Processing Systems (SiPS), pp.71-76).

In one embodiment, a bias voltage may be applied to current source transistor T2,T2'. The value of the bias voltage VB and the dimension of transistor T2,T2' determine the current of an active unit cells, which in turn determines the output power of a radio transmitter device. While the current is constant when the cell is in operation (and thus contributing to the modulation), the current may be adjusted to control the RMS output power of the transmitter and thus its gain.

In one embodiment, the cascode transistor T3, T3' is a thick oxide transistor. The thick oxide transistor shields the conversion cell from a high voltage swing at its output. As a result, higher output power can be provided by the DDRM, as the fast low voltage switch transistor T1,T1' and the current source T2,T2' are shielded from the high output voltage swing.

In another embodiment, the current source transistor T2,T2' is a thin oxide transistor which has better matching performance than thick oxide transistors. This results in a reduced area for a given resolution. Thin oxide transistor T2,T2' is also shielded from the high output swing by the thick-oxide cascode transistor T3,T3'.

The present disclosure also relates to a front-end system 100 comprising a DDRM modulator 10. As explained above, the DDRM modulator 10 receives at its input IN,IN' a multi-bit digital signal D,D' provided by a digital circuit 20, such as a digital signal processor (DSP). The front-end system 100 may operate with either Cartesian (I/Q data) or polar data. In both implementations, the DSP 20 receives at its input baseband data, for example I/Q data or polar data, and a local oscillator signal LO. It optionally processes the baseband data before combining it with the LO signal to create a modulated LO signal. The DSP, thus, outputs a multi-bit digital signal D,D' which is the modulated LO signal. Depending on the implementation, Cartesian or polar, differential or single-ended, the DSP 20 receives a single-phase, a two-phase or a four-phase LO signal. For example, for a Cartesian differential implementation, the DSP receives a baseband I/Q data of 2n bits (1n bits for each I and Q baseband phase) and a four-phase LO signal. The LO signal and the corresponding baseband data are combined together to form a modulated LO signal - the multi-bit digital signal D,D'. In the given examples these would be combined to a 4n wide modulated I/Q LO stream (1n for positive I modulated LO stream, 1n for the negative one, and similar for both positive and negative Q modulated LO streams). The modulated LO signal is then used as input to the DDRM 10 to define which DDRM conversion cells CCi should be activated or not. Accordingly, the DDRM 10 performs the conversion of the modulated LO signal into an analog RF signal OUT. Note that the duty cycle of the I/Q modulated LO signal is defined by the LO signal applied to 20, and should meet the requirements discussed above. As another example, in a single-ended polar implementation, an n-bit wide amplitude BB data would be combined with the phase modulated LO, to generate a n-bit wide phase (from the LO) and amplitude (from the n-bit lines) modulated LO stream is applied to the n conversions cells CCi.

By integrating the modulator 21 inside the DSP 20, a I/Q modulated LO stream is created and distributed to the DDRM 10. In the I/Q modulated LO stream, the switching activity is limited to the lines going to the unit cells active at a certain moment. As an example, in the case of a thermometer coded DDRM, the switching activity would be proportional to the amplitude of the baseband signal, as for higher amplitude more thermometer coded elements would be activated. This limited switching activity is in contrast with traditional implementations in which the active LO phases is distributed to all the DDRM units, even the ones that don't need it at a given moment. This approach results in lower power consumption, as less power is lost in the switching activity of the long lines. It also results in lower LO feedthrough, as less LO activity is present in the DDRM cells.

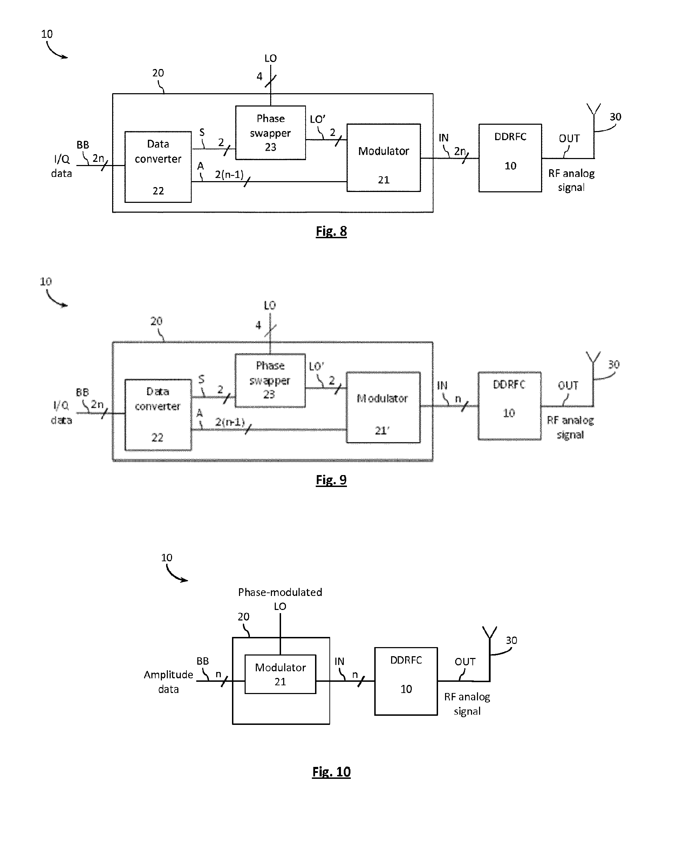

Fig.8 shows an exemplary implementation of a front-end system 100 for a Cartesian differential digital transmitter comprising a Cartesian DDRM 10. The DSP 20 receives at its inputs a multi-phase local oscillator LO signal and an I/Q baseband data consisting of an n-bit wide digital data stream for I baseband phase and an n-bit wide digital data stream for Q baseband phase. The digital baseband data is applied to a data converter 22 which conditions the data before further digital processing. The converter 22 may comprise additional digital circuits arranged for performing digital processing such as up-conversion, digital filtering, interpolation or binary to thermometer decoding. The baseband data at the output of 22 is formatted (or split) as I/Q sign bits S and amplitude bits A. The sign bits S of I and Q are then provided to a phase swapper 23. The phase swapper 23 selects and routes the appropriate LO phases to the modulator 21 based on the sign bit of the I and Q baseband data. The phase swapper 23 may comprise a plurality of switches (i.e. transistors operating as switches) to route a respective phase of the LO signal to the modulator 21 based on the received sign bits S. Alternatively, the same function can be obtained with logical gates. Based on the sign of the I and Q baseband data, the correct LO phase of the multi-phase LO signal is selected to be fed to a modulator 21. As an example, in a single ended implementation, for a positive I baseband, the 0° phase of the LO signal is selected and routed to the modulator 21. For a negative I baseband, the 180° phase of the LO signal is selected and routed. The output signal LO' of the phase swapper 23 is then combined with the baseband amplitude bits A in a modulator 21 to generate a modulated LO signal. The modulated LO signal is in fact a multi-bit digital signal D,D' which consists of 2xn digital bit streams (4n in case of a differential implementation), n bits for each positive and negative I and Q LO modulated signal, respectively. The modulated LO signal is then fed to the DDRM for a direct conversion from a digital to an analog RF signal.

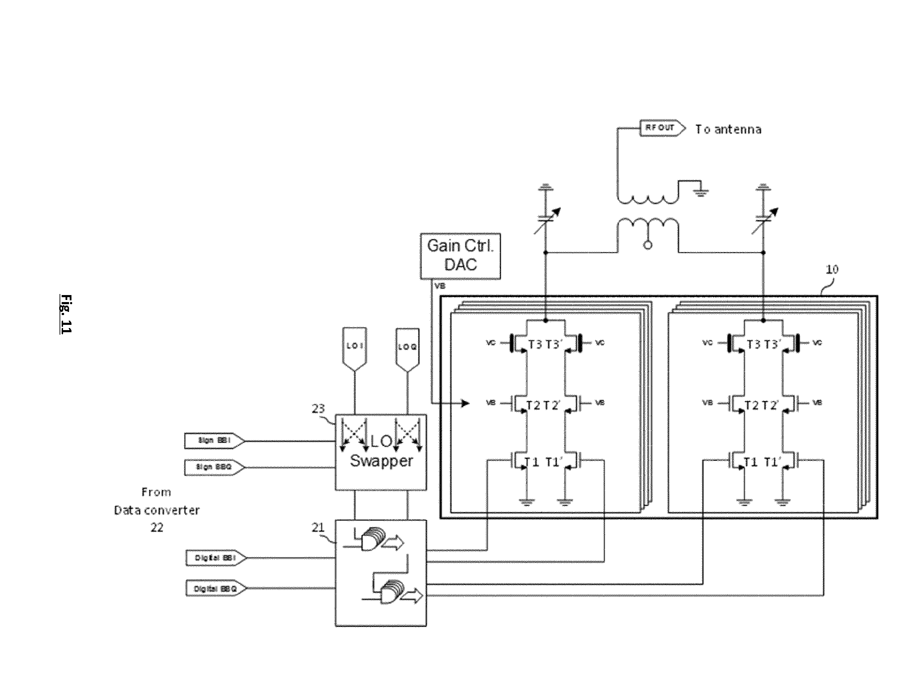

This is explained more in detail with reference to Fig.11, which shows a more detailed schematic diagram of the differential implementation of Fig.8. The data modulator 21 comprises a plurality of AND logic gates. Each AND logic gate combines a respective LO phase with a corresponding I or Q bit. The DDRM 10 comprises a 2n conversion cells CC, n cells for the amplitude modulation of the positive I and Q phases and n cells for the amplitude modulation of the negative I and Q phases. Both the conversion cells of Fig.6A and Fig.7A may be used. Thus one set of n conversion cell generating the positive RF analog signal RF+ and the other set of n conversion cells generating the negative RF analog signal RF+ at the differential output OUT. The currents from the two sets of conversion cells RF+,RF- are then combined at the positive and negative side of the transmitter to form the RF differential analog signal. This RF signal is then applied to a tuned balun to be converted into a single ended output which is then send for transmission via the antenna.

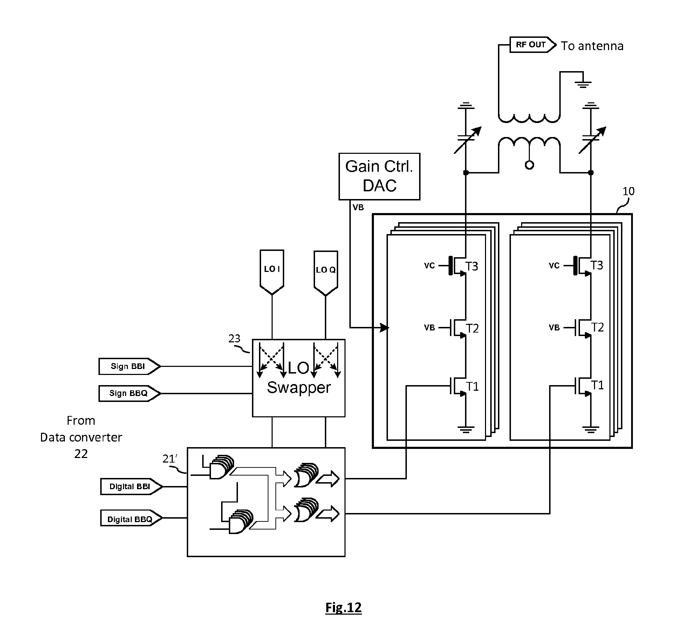

Fig.9 shows another exemplary implementation of a front-end system 100 for a Cartesian differential digital transmitter comprising a Cartesian DDRM 10. In this embodiment, the implementation of the DSP 20 defers from the implementation of Fig.8. Herein, in addition to the plurality of AND logic gates, the modulator 21' comprises a plurality of XOR logic gates for combining the I modulated and the Q modulated LO signal into a single data stream. In this case, the number of digital streams being fed to the DDRM 10 is halved compared to the embodiment of Fig. 8. This is shown with more details in Fig.12. As the DDRM 10 is fed with a single data stream, the DDRM needs to only perform the conversion of the digital data stream into an analog RF signal. The implementation of the DDRM 10 is thus simpler, i.e. comprises twice less conversion cells as in comparison to the implementation of Fig.8. For a single-ended implementation, the DDRM 10 comprises one set of n conversion cells as of Fig.5. For a differential implementation, the DDRM 10 needs to comprise 2 sets of n conversion cell as of Fig.5.

Fig.10 shows another exemplary implementation of a front-end system 100 for a polar digital transmitter. In contrary to the implementations of Fig.8 and Fig. 9, the DSP 20 herein receives at its input an amplitude baseband data and a phase-modulate LO signal. The implementation of the DSP is simpler as it only needs a modulator circuit 21 for the combination of the two signals at its input. Optionally, it may comprise a data converter 22 for conditioning, for example, for up-converting, filtering, interpolating or for binary to thermometer decoding, the baseband data before being fed to the modulator 21. Similarly to the previous embodiment, the DDRM 10 comprises a single set of n conversion cells as of Fig.5.

The present disclosure further relates to a radio device comprising a front-end system 100 and to a communication network comprising at least one such radio device.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1.  Direct digital radio frequency modulator (10) comprising a plurality of input terminals (11) arranged for being fed with a multi-bit digital signal (D), a plurality of converter circuits (CCi), each converter circuit being arranged for receiving at an input terminal one bit of said multi-bit digital signal and for outputting at a converter circuit output terminal (OUTi) an analog signal (Ai) in accordance to said one bit, each converter circuit comprising an input transistor (T1) arranged for receiving said one bit for enabling the converter circuit to produce said analog signal, a current source transistor (T2) and a frequency modulator output terminal (12) connected to the output terminal of each converter circuit for providing an analog output signal (A), **characterized in that** said converter circuit further comprises an additional transistor (T3) in cascode to said current source transistor (T2).

2.  Direct digital radio frequency modulator as in claim 1, comprising a circuit arranged for summing said analog signal produced by each respective converter circuit to form said analog output signal (A) at said frequency modulator output terminal.

3. Direct digital radio frequency modulator as in claim 1 or 2, wherein said multi-bit digital signal is a modulated radio frequency multi-bit digital signal.

4. Direct digital radio frequency modulator as in claim 3, wherein said modulated radio frequency multi-bit digital signal is a modulated I/Q data signal or a modulated polar data signal.

5. Direct digital radio frequency modulator as in any of the previous claims, wherein said current source transistor in each respective converter circuit is configured to receive a bias voltage.

6. Direct digital radio frequency modulator as in any of the previous claims, wherein said additional transistor is a thick-oxide transistor.

7. Front-end radio system comprising: a direct digital radio frequency modulator as in any of the previous claims and a digital signal processor arranged for outputting said multi-bit digital signal.

8. Front-end radio system as in claim 7, wherein said digital signal processor comprises a modulator circuitry arranged for modulating a digital baseband signal with a radio frequency signal and for outputting said multi-bit digital signal.

9. Radio device comprising a front-end radio system as in claim 7 or 8.

10. Communication network comprising at least one radio device as in claim 9.

**Fig. 1**

**Fig. 2**

10

CC1

OUT1

A1

CCn

12

ADD    A    OUT

RF analog
signal

11    n    D    IN1    D1

IN                    1bit

digital
data

INn    Dn

1bit

**Fig. 3**

CCi    OUTi

VC    T3

VB    T2

Di    INi    T1
1bit

**Fig. 4**

**Fig. 5**

**Fig. 6A**

**Fig. 6B**

INi

INi'

OUTi

**Fig. 6C**

CCi

OUTi

VC — T3

VB — T2

INi — Di 1bit — T1 T1' — INi' — Di' 1bit

**Fig. 7A**

INi — Di

INi' — Di'

OUTi

**Fig. 7B**

10

20

LO

4

BB
I/Q
data
2n

Data
converter

22

S
2

Phase
swapper

23

LO'
2

Modulator

21

IN
2n

DDRFC

10

OUT

30

RF analog
signal

A
2(n-1)

**Fig. 8**

10

20

LO

4

BB
I/Q
data
2n

Data
converter

22

S
2

Phase
swapper

23

LO'
2

Modulator

21'

IN
n

DDRFC

10

OUT

30

RF analog
signal

A
2(n-1)

**Fig. 9**

10

Phase-modulated
LO

20

Amplitude
data

BB
n

Modulator

21

IN
n

DDRFC

10

OUT

30

RF analog
signal

**Fig. 10**

**Fig. 11**

**Fig.12**

Europäisches
Patentamt

European
Patent Office

Office européen
des brevets

# EUROPEAN SEARCH REPORT

Application Number

EP 15 18 4603

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/191976 A1 (SHAKESHAFT NIALL E [FI] ET AL) 1 September 2005 (2005-09-01) * paragraphs [0070], [0071]; figures 1,1b,3,4 * * paragraph [0004] - paragraph [0014] * | 1-10 | INV. H03K5/01 H04B1/04 |
| X A | EP 2 184 859 A1 (PANASONIC CORP [JP]) 12 May 2010 (2010-05-12) * paragraph [0099] - paragraph [0107]; figure 5 * | 1-6 7-10 | |
| X | US 2011/025415 A1 (MU FENGHAO [SE]) 3 February 2011 (2011-02-03) * paragraph [0041] - paragraph [0042]; claim 1; figure 5 * | 1-10 | |
| X | US 2007/275676 A1 (ROFOUGARAN AHMADREZA REZA [US] ET AL) 29 November 2007 (2007-11-29) * paragraph [0030] - paragraph [0045]; figures 1,3A, 3B * | 1-10 | TECHNICAL FIELDS SEARCHED (IPC) H03K H04B |

The present search report has been drawn up for all claims

| Place of search | Date of completion of the search | Examiner |
|---|---|---|
| Munich | 8 February 2016 | Riccio, Ettore |

EPO FORM 1503 03.82 (P04C01)

## ANNEX TO THE EUROPEAN SEARCH REPORT
## ON EUROPEAN PATENT APPLICATION NO.

EP 15 18 4603

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2016

| Patent document cited in search report | | Publication date | Patent family member(s) | | Publication date |
|---|---|---|---|---|---|
| US 2005191976 | A1 | 01-09-2005 | CN 101167324 A<br>EP 1875701 A1<br>KR 20080003451 A<br>US 2005191976 A1<br>WO 2006117589 A1 | | 23-04-2008<br>09-01-2008<br>07-01-2008<br>01-09-2005<br>09-11-2006 |
| EP 2184859 | A1 | 12-05-2010 | CN 101657972 A<br>EP 2184859 A1<br>JP 5066176 B2<br>US 2010182180 A1<br>WO 2009028130 A1 | | 24-02-2010<br>12-05-2010<br>07-11-2012<br>22-07-2010<br>05-03-2009 |
| US 2011025415 | A1 | 03-02-2011 | US 2011025415 A1<br>WO 2011015533 A1 | | 03-02-2011<br>10-02-2011 |
| US 2007275676 | A1 | 29-11-2007 | US 2007275676 A1<br>US 2009163156 A1 | | 29-11-2007<br>25-06-2009 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **CHUNSHU LI.** Efficient self-correction scheme for static non-idealities in nano-scale quadrature digital RF transmitters. *IEEE Workshop on Signal Processing Systems (SiPS),* 2013, 71-76